# EUROPÄISCHE PATENTSCHRIFT

(11) **EP 2 988 903 B1**
(45) Veröffentlichungstag und Bekanntmachung des Hinweises auf die Patenterteilung: **30.08.2017**
(21) Anmeldenummer: 14725021.1
(22) Anmeldetag: 24.04.2014
(51) Int. Cl.: B23K 26/00, B23K 26/40, H01L 21/78

(54) **VERFAHREN ZUR VEREINZELUNG VON CHIPS AUS EINEM WAFER UND HERGESTELLTE CHIPS DAVON**
PROCESS FOR THE SEPARATION OF CHIPS FROM A WAFER AND CHIPS MANUFACTURED WITH SUCH PROCESS
PROCÉDÉ DE SÉPARATION INDIVIDUELLE DE PUCES À PARTIR D'UNE PLAQUETTE ET PUCES AINSI PRODUITES

(30) Priorität: 24.04.2013 DE 102013207480
(43) Veröffentlichungstag der Anmeldung: 02.03.2016
(73) Patentinhaber: SMARTRAC TECHNOLOGY GmbH, 01099 Dresden (DE)
(72) Erfinder: KRIEBEL, Frank, 01896 Lichtenberg (DE); SINGLETON, Laurence, 01307 Dresden (DE); NIELAND, Carsten, 99867 Gotha (DE)
(74) Vertreter: advotec.
(86) Internationale Anmeldenummer: PCT/EP2014/058316
(87) Internationale Veröffentlichungsnummer: WO 2014/173999

(56) Entgegenhaltungen:
- EP-A1- 1 338 371
- EP-A1- 1 875 983
- EP-A1- 2 040 286
- EP-A2- 1 570 941
- US-A1- 2007 111 478
- US-A1- 2007 111 481
- US-A1- 2011 312 193

## Beschreibung

Die Erfindung betrifft ein Verfahren zur Vereinzelung von Chips aus einem Wafer gemäß dem Oberbegriff des Anspruchs 1, durch Teilung des Wafers längs Abmessungen des Chips definierenden Teilungslinien, wobei ein Fokus einer gepulsten Laserstrahlung längs den Teilungslinien auf einem ersten und zumindest einem zweiten Pfad innerhalb des Waferkörpers bewegt wird, wobei der erste Pfad zwischen einer an der Vorderseite des Wafers angeordneten Funktionsschicht und dem zweiten Pfad verläuft, derart, dass auf den Pfaden infolge partiellen Aufschmelzens des monokristallinen Siliziumkörpers polykristalline Fehlstellen zur Erzeugung innerer Spannungen im Siliziumkörper ausgebildet werden, und wobei nachfolgend der Erzeugung eines Pfadsystems aus ersten und zweiten Pfaden eine Beaufschlagung des Wafers mit einer mechanischen Belastung erfolgt zur Vereinzelung der Chips aus dem Wafer infolge eines Materialbruchs in durch den ersten und zweiten Pfad definierten Teilungsebenen, die die Seitenflächen der Chips ausbilden. Des Weiteren betrifft die Erfindung einen Chip gemäß dem Oberbegriff des Anspruchs 6, mit einem Halbleiterkörper aus Silizium und einer an einer Vorderseite des Halbleiterkörpers ausgebildeten, durch eine Halbleiterbasis von einer Rückseite des Halbleiterkörpers beabstandeten Funktionsschicht, wobei der Halbleiterkörper Seitenflächen aufweist mit Oberflächenbereichen, die eine unterschiedliche Topographie aufweisen und die zumindest zwei mit Abstand von der Rückseite auf den Seitenflächen verlaufende, durch Fehlstellen der Oberfläche des Halbleiterkörpers markierte Pfade aufweisen, wobei der erste Pfad zwischen der Funktionsschicht und dem zweiten Pfad angeordnet ist.

Bei dem Verfahren der eingangs genannten Art, das fachterminologisch auch unter dem Begriff "Stealth Dicing" bekannt ist, werden durch eine Laserbeaufschlagung des Wafers im Inneren des Waferkörpers Fehl- oder Schwachstellen in der kristallinen Struktur des Wafers unterhalb der Waferoberfläche und damit verdeckt erzeugt, die bei einer nachfolgenden mechanischen Belastung zu einem Brechen des Wafers längs der durch die Fehlstellen definierten Pfade im Inneren des Wafers führen.

Die Ausbildung der Fehlstellen erfolgt durch ein partielles oder diskret lokales Aufschmelzen punktueller Bereiche im Siliziumkörper mit der Folge, dass sich in den aufgeschmolzenen Bereichen das monokristalline Silizium in polykristallines Silizium umwandelt, das im Vergleich zum monokristallinen Silizium ein größeres Volumen aufweist, so dass entsprechende Druckspannungen im Inneren des Siliziumkörpers erzeugt werden, die bei Überlagerung mit Spannungen, die durch eine äußere Belastung des Wafers im Inneren des Wafers induziert werden, zu einem Bruch des Wafers in den durch die Fehlstellen definierten Ebenen führen.

Zur eindeutigen Definition der vorgenannten Spannungs- oder Teilungsebenen ist es aus der EP 1 338 371 A1 bekannt, zwei in einer Ebene senkrecht zur Oberfläche des Wafers angeordnete Pfade zu erzeugen, die durch eine linienförmige Anordnung einer Vielzahl von Fehlstellen im Inneren des Siliziumkörpers definiert sind. Bei einer Überlagerung der in der Spannungsebene durch die Fehlstellen erzeugten inneren Spannungen des Siliziumkörpers mit einer durch eine äußere Belastung induzierten Spannung bilden sich in einem Bereich zwischen den Pfaden mikroskopische Brüche, so genannte "Wallner-Linien", aus, die zum Bruch des Waferkörpers und bei entsprechender Verteilung bzw. Anordnung der Pfade im Siliziumkörper des Wafers zu einer Aufteilung des Siliziumwafers in die einzelnen Chips führen.

Bei Untersuchungen der nach dem bekannten Verfahren durch Vereinzelung aus dem Waferkörper hergestellten Chips hat sich herausgestellt, dass tatsächlich die Ausbreitung der Mikrorisse im Inneren des Siliziumkörpers nicht nur in einem ebenen Bereich zwischen den durch die Pfade in der kristallinen Struktur des Siliziumkörpers ausgebildeten Störungslinien erfolgt, sondern dass vielmehr sich die Mikrorisse auch über den durch die Störungslinien begrenzten Bereich hinaus ausdehnen.

Insbesondere dann, wenn eine derartige Rissausdehnung über die der aktiven Schicht oder Funktionsschicht des Halbleiterkörpers zugewandte Störungslinie erfolgt, besteht die Gefahr, dass die Mikrorisse bis dicht benachbart an die Funktionsschicht heranreichen oder diese sogar erreichen. Selbst wenn die Funktionsschicht der Halbleiterkörper der durch Vereinzelung aus dem Wafer entstandenen Chips infolge der Herstellung der Chips, also der Vereinzelung der Chips aus dem Waferkörper, nicht beeinträchtigt werden sollte, besteht natürlich bei Chips, die nach den bekannten Verfahren hergestellt sind, stets das Risiko, dass infolge einer bei der Handhabung des Chips bzw. der mit einem derartigen Chip versehenen Vorrichtung und einer mit dieser Handhabung verbundenen äußeren Belastung des Chips bzw. der Vorrichtung bis in die Nachbarschaft der Funktionsschicht reichende Mikrorisse sich weiter ausdehnen und zu einem Ausfall des Chips führen.

Aufgrund ihrer bestimmungsgemäßen Verwendung sind dabei insbesondere Chips gefährdet, die entweder durch die Art und Weise ihrer Applikation oder durch den Gebrauch einer mit dem Chip versehenen Vorrichtung einer Biegebeanspruchung unterliegen. Dies ist insbesondere bei sehr dünnen Chips der Fall, die in Tags, also etwa Etiketten, oder Chipkarten Verwendung finden und die zum Teil sogar noch nachfolgend der Vereinzelung aus einem Waferkörper zur Erzielung möglichst dünner Chips gedünnt werden, also eine reduzierte Halbleiterbasis und damit verbunden eine entsprechend reduzierte Steifigkeit aufweisen. US 2011/0312193 A1 offenbart ein Verfahren gemäß dem Oberbegriff des Anspruchs 1. EP 1 570 941 A2 offenbart ein Chip gemäß dem Oberbegriff des Anspruchs 6. Der vorliegenden Erfindung liegt die Aufgabe zugrunde, ein Verfahren zur Herstellung von Chips bzw. Chips vorzuschlagen, die im Vergleich zu den mit den bekannten Verfahren hergestellten Chips eine geringere, durch unkontrollierte Rissbildung bedingte Ausfallwahrscheinlichkeit aufweisen.
Zur Lösung dieser Aufgabe weist das erfindungsgemäße Verfahren die Merkmale des Anspruchs 1 auf.
Erfindungsgemäß erfolgt die Laserbeaufschlagung des Wafers von einer Rückseite des Wafers her. Die Leistungsdichte zur Erzeugung der Fehlstellen auf dem ersten Pfad ist geringer als die Leistungsdichte zur Erzeugung der Fehlstellen auf dem zweiten Pfad, und/oder die Anzahl der Fehlstellen auf dem ersten Pfad ist kleiner als die Anzahl der Fehlstellen auf dem zweiten Pfad, derart, dass ein abfallender Spannungsgradient zwischen den längs dem zweiten Pfad und dem ersten Pfad durch die Fehlstellen induzierten inneren Spannungen ausgebildet wird, und der erste Pfad eine Barriere gegen eine Rissausweitung über den ersten Pfad hinaus in Richtung auf die Funktionsschicht des Wafers ausbildet. Durch die Beaufschlagung der fokussierten Stellen längs des ersten Pfads mit einer relativ geringeren Leistungsdichte als bei der Beaufschlagung der fokussierten Stellen des zweiten Pfads wird eine Anpassung des wirksamen Energieeintrags an die Lage der Pfade innerhalb des Waferkörpers bzw. an den jeweiligen Abstand der Pfade von der Funktionsschicht ermöglicht. Hierbei wird von der Erkenntnis ausgegangen, dass ein geringerer Energieeintrag zur Erzeugung der Fehlstellen längs des ersten Pfads, also des relativ dichter zur Funktionsschicht angeordneten Pfads, zur Ausbildung kleinerer Fehlstellen bzw. zu einer Induzierung von vergleichsweise geringeren Spannungen innerhalb des Siliziumkörpers führt. Die vergleichweise größeren inneren Spannungen werden daher längs des zweiten Pfads induziert, wobei sich in Untersuchungen herausgestellt hat, dass dieses relative Spannungsgefälle vom zweiten Pfad zum ersten Pfad dazu führt, dass bei einer Ausbildung von Spannungsrissen infolge einer äußeren Biege- und/oder Zugbelastung des Wafers, ausgehend von dem zweiten Pfad sich Mikrorisse ausbilden und der erste Pfad als Barriere hinsichtlich einer Rissausweitung über den ersten Pfad hinaus in Richtung auf die Funktionsschicht des Wafers wirkt.

Es wird betont, dass das erfindungsgemäße Verfahren sowie der erfindungsgemäße Chip nicht in jedem Fall einen Siliziumkörper voraussetzen, sondern dass vielmehr grundsätzlich eine kristalline Struktur, insbesondere eine kristalline Halbleiterstruktur, bereitgestellt werden muss. Insofern ist der Begriff "Siliziumkörper" genauso wenig wie der Begriff "Halbleiterkörper aus Silizium" einschränkend sondern lediglich beispielhaft zu verstehen.

Zusätzlich oder alternativ zur Erzeugung der Fehlstellen auf dem ersten und zweiten Pfad mit differenzierter Leistungsdichte kann eine gegenüber dem ersten Pfad relativ höhere induzierte Spannung längs dem zweiten Pfad dadurch erreicht werden, dass die Anzahl der Fehlstellen auf dem ersten Pfad kleiner ist als die Anzahl der Fehlstellen auf dem zweiten Pfad. Bereits bei einer übereinstimmenden Leistungsdichte bei der Erzeugung der Fehlstellen des ersten Pfads und des zweiten Pfads kann eine vergleichsweise höhere Spannung auf dem zweiten Pfad dadurch erzeugt werden, dass der zweite Pfad eine höhere Anzahl von Fehlstellen oder eine höhere Dichte, also einen geringeren Abstand zwischen benachbarten Fehlstellen, aufweist.

Vorzugsweise ist die Differenz der Leistungsdichte zur Erzeugung der Fehlstellen auf dem ersten Pfad zur Leistungsdichte zur Erzeugung der Fehlstellen auf dem zweiten Pfad so gewählt wird, dass die Seitenflächen der Chips in einem Oberflächenbereich zwischen dem ersten Pfad und der Vorderseite der Chips gegenüber einem Oberflächenbereich zwischen dem ersten Pfad und dem zweiten Pfad eine geringere Rauheit aufweisen.

Vorzugsweise ist die Differenz der Anzahl der Fehlstellen auf dem ersten Pfad gegenüber der Anzahl der Fehlstellen auf dem zweiten Pfad so gewählt wird, dass die Seitenflächen der Chips in einem Oberflächenbereich zwischen dem ersten Pfad und der Vorderseite der Chips gegenüber einem Oberflächenbereich zwischen dem ersten Pfad und dem zweiten Pfad eine geringere Rauheit aufweisen.

Als besonders vorteilhaft erweist es sich, wenn die Erzeugung des ersten Pfads vor Erzeugung des zweiten Pfads erfolgt, da in Kombination mit der rückwärtigen Beaufschlagung des Wafers mit Laserenergie auf diese Art und Weise ausgeschlossen werden kann, dass die Pfade sich gegenseitig beeinflussen, also etwa die Position einer Fehlstelle auf dem zweiten Pfad die übereinstimmende Positionierung einer Fehlstelle auf dem ersten Pfad verhindern würde.

Wenn gemäß einer bevorzugten Ausführungsform des Verfahrens der zweite Pfad benachbart zu oder in einer Mittelebene des Wafers erzeugt wird, ist die im Bereich des zweiten Pfads induzierte Spannung im Wesentlichen unabhängig von einer äußeren Biegebelastung des Wafers.

Je nach Gesamtdicke bzw. Höhe des Waferkörpers sowie dem Grad der Dotierung haben sich unterschiedliche Größen der Leistungsdichte zur Erzeugung der Fehlstellen des ersten Pfads im Verhältnis zu der Leistungsdichte zur Erzeugung der Fehlstellen des zweiten Pfads herausgestellt. Bei einer Waferdicke von etwa 120 µm ist es besonders vorteilhaft, wenn die Leistungsdichte zur Erzeugung der Fehlstellen des ersten Pfads maximal 75 % der Leistungsdichte zur Erzeugung der Fehlstellen des zweiten Pfades beträgt. Eine Leistungsdichte von 80 bzw. 90 % der Leistungsdichte zur Erzeugung der Fehlstellen des zweiten Pfades kann sich daher bei dünner ausgebildeten Waferkörpern als vorteilhaft erweisen.

Als besonders vorteilhaft hat es sich herausgestellt, wenn ein dritter Pfad zwischen der Mittelebene und der Rückseite des Wafers erzeugt wird, so dass ein mit nachfolgenden vorteilhaften Ausführungsformen beispielhaft angeführter Gradient der längs den Pfaden induzierten Spannungen im Inneren des Siliziumkörpers zwischen dem dritten Pfad und dem zweiten Pfad einstellbar ist. Insbesondere kann durch Erzeugung eines dritten Pfades die Leistungsdichte für die Pfade so gewählt werden, dass sich sowohl vom zweiten Pfad zum ersten Pfad als auch vom zweiten Pfad zum dritten Pfad ein abfallender Gradient einstellt.
Auch im Falle der Erzeugung eines dritten Pfades haben sich unterschiedliche relative Leistungsdichten zur Erzeugung der Fehlstellen des dritten Pfads als vorteilhaft herausgestellt, so dass etwa bei einem Waferkörper mit einer Dicke von etwa 120 µm die Leistungsdichte zur Erzeugung der Fehlstellen des dritten Pfads mit 30 % der Leistungsdichte zur Erzeugung der Fehlstellen des zweiten Pfads besonders vorteilhaft gewählt ist.
In weiteren vorteilhaften Ausgestaltungen beträgt die relative Leistungsdichte 40 bzw. 50 % der Leistungsdichte zur Erzeugung der Fehlstellen des zweiten Pfads.
Zur Lösung der eingangs genannten Aufgabe weist der erfindungsgemäße Chip die Merkmale des Anspruchs 6 auf. Erfindungsgemäß weist der Halbleiterkörper des Chips Seitenflächen auf, die zwischen einem ersten und einem zweiten Pfad einen ersten Oberflächenbereich aufweisen. Der erste Pfad bildet eine Barriere aus, die den ersten Oberflächenbereich von einem zwischen der Funktionsschicht und der Barriere ausgebildeten zweiten Oberflächenbereich trennt, wobei der zweite Oberflächenbereich eine geringere Oberflächenrauheit als der erste Oberflächenbereich aufweist, und der erste Oberflächenbereich Mikrorisse aufweist.

Der erfindungsgemäße Chip weist daher bereits rein äußerlich an der Topographie der Seitenflächen erkennbar einen Oberflächenbereich zwischen dem ersten und dem zweiten Pfad auf, der eine relativ große Oberflächenrauheit aufweist, die aus der Ausbildung der Mikrorisse während der Vereinzelung der Chips aus dem Waferkörper resultiert. Im Gegensatz zu diesem Oberflächenbereich weist der durch den ersten Pfad abgeteilte, der Funktionsschicht zugewandte Oberflächenbereich eine vergleichsweise geringe Rauheit auf, so dass sich innerhalb dieses Oberflächenbereichs auch eine vergleichsweise geringe Kerbwirkung infolge einer äußeren Belastung des Chips einstellt. Damit ist im Vergleich zu einem Chip, der auch in dem Oberflächenbereich zwischen dem ersten Pfad und der Funktionsschicht eine relativ große Rauheit aufweist, bei dem erfindungsgemäßen Chip eine geringere Wahrscheinlichkeit gegeben, dass sich bei einer äußeren Biegebelastung des Chips ausgehend von dem der Funktionsschicht zugewandten Oberflächenbereich weitere, möglicherweise bis in die Funktionsschicht hineinreichende Mikrorisse ausbilden.
Wenn gemäß einer bevorzugten Ausführungsform die Anzahl der Fehlstellen auf dem ersten Pfad kleiner ist als die Anzahl der Fehlstellen auf dem zweiten Pfad, ist das Risiko einer Ausbildung von Mikrorissen in dem der Funktionsschicht zugewandten Oberflächenbereich der Seitenflächen noch weiter reduziert. Wenn der Oberflächenbereich mit erhöhter Rauheit Mikrorisse aufweist, die häufig auch als "Wallner-Linien" bezeichnet werden, wobei sich die Mikrorisse bis zum ersten Pfad erstrecken, ist aufgrund der in ihrer Länge durch den ersten Pfad begrenzten Mikrorisse rein äußerlich erkennbar, dass der betreffende Chip eine vergleichsweise geringe Ausfallwahrscheinlichkeit aufgrund mechanischer Belastung aufweist.
Vorteilhaft wird die Anordnung der Pfade so gewählt, dass bei äußerer Belastung des Wafers die Rissbildung zur Trennung der Chips gezielt von dem Bereich zwischen dem ersten und dem zweiten Pfad ausgeht und diese Pfade verbindet.

Besonders vorteilhaft hinsichtlich einer hohen mechanischen Belastbarkeit und verbunden damit einer geringen Ausfallwahrscheinlichkeit erweist es sich, wenn der zweite Pfad benachbart zu oder auf einer Mittellinie der Seitenfläche verläuft.

Ein Chip mit einer hohen mechanischen Belastbarkeit und eine daraus resultierende entsprechend geringe Ausfallwahrscheinlichkeit des Chip wird möglich, wenn der zweite Pfad in einem Oberflächenbereich der Seitenfläche verläuft, der durch die Mittellinie und die Rückseite des Halbleiterkörpers begrenzt ist, und der zweite Pfad in einem Abstand m von der Mittellinie verläuft, der 30 % der Höhe h des Halbleiterkörpers entspricht.

Wie sich in Versuchen herausgestellt hat, lässt sich die mechanische Belastbarkeit des Chips dadurch positiv beeinflussen, dass insbesondere in Abhängigkeit von der Höhe h des Halbleiterkörpers, der erste Pfad in einem definierten Abstand von der Vorderseite des Halbleiterkörpers verläuft. Bei einem etwa 120 µm dicken Halbleiterkörper, hat sich als vorteilhaft herausgestellt, wenn dieser Abstand größer ist als 30 % des Abstands h/2 der Vorderseite von der Mittellinie der Seitenfläche.

Mit zunehmender Reduzierung der Dicke bzw. Höhe des Halbleiterkörpers hat sich ein entsprechend zunehmender Abstand des ersten Pfades von der Vorderseite des Halbleiterkörpers, also etwa 40 oder 50 % des Abstands h/2 der Vorderseite von der Mittellinie der Seitenfläche, als vorteilhaft herausgestellt.

In jedem Fall hat es sich als vorteilhaft herausgestellt, wenn der dritte Pfad in einem Abstand c von der Rückseite des Halbleiterkörpers verläuft, der größer ist als 10 % der Höhe des Halbleiterkörpers.

Nachfolgend werden eine Möglichkeit zur Ausführung des erfindungsgemäßen Verfahrens sowie Ausführungsformen von mit diesem Verfahren herstellbaren Chips anhand der Zeichnung näher erläutert.

Es zeigen:
- **Fig. 1**: einen Wafer, der, wie durch die Teilungslinien angedeutet, zur Vereinzelung in eine Vielzahl einzelner Chips vorgesehen ist;
- **Fig. 2**: ein Segment des in **Fig. 1** dargestellten Wafers mit einem durch die Teilungslinien in seinen Abmessungen definierten Chip während der Teilung des Wafers;
- **Fig. 3**: den durch Teilung aus dem in **Fig. 2** dargestellten Wafersegment hergestellten Chip in isometrischer Darstellung;
- **Fig. 4**: eine zu dem in **Fig. 3** dargestellten Chip alternative Ausführungsform eines durch Teilung aus einem Wafer hergestellten Chips.

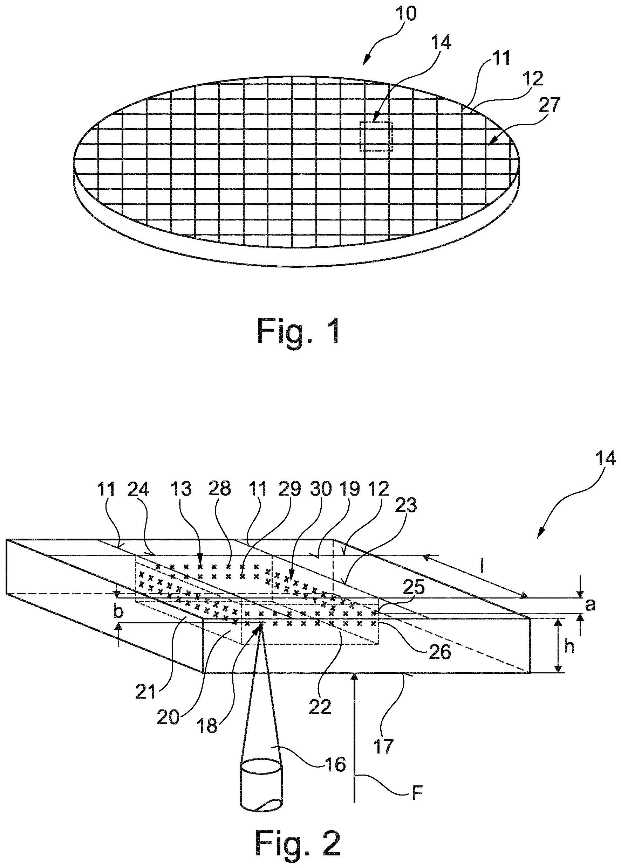

**Fig. 1** zeigt einen Wafer 10, der auf der Oberfläche seiner Vorderseite 19 mit orthogonalen Teilungslinien 11, 12 eines Teilungsrasters 27 versehen ist, die Abmessungen von Chips 13 (**Fig. 2**) festlegen, welche durch das nachfolgend erläuterte Verfahren durch Teilung des Wafers 10 in einzelne Chips 13 hergestellt werden.

Wie aus der isometrischen Darstellung eines Wafersegments 14 deutlich wird, definieren die Teilungslinien 11, 12 die Abmessungen des Chips 13 in der Waferebene, also die Länge und die Breite des Chips, die im vorliegenden Fall übereinstimmen, so dass der Chip 13 in der Waferebene eine Kantenlänge 1 aufweist. Die Höhe des Chips 13 ist durch die Dicke h des Wafers 10 definiert.

Bei dem Verfahren zur Vereinzelung von Chips 13 aus dem in **Fig. 2** dargestellten Wafersegment 13 des Wafers 10 wird der Wafer 10 mit einer Laserstrahlung 16 beaufschlagt wird, derart, dass eine Rückseite 17 des Wafers 10 mit der Laserstrahlung 16 beaufschlagt wird, die so fokussiert ist, dass ein Fokus 18 sich in einem definierten Abstand von der Vorderseite 19 des Wafers 10 befindet.

Wie aus der Darstellung in **Fig. 2** hervorgeht, definieren die Teilungslinien 11, 12 in einem Siliziumkörper 20 des Wafers 10 die Lage von Teilungsebenen 21, 22, 23 und 24, die senkrecht zur Vorderseite 19 des Wafers 10 angeordnet sind, und in denen der Fokus 18 der Laserstrahlung 16 entlang definierter Pfade 25, 26 bewegt wird. Dabei wird der Fokus längs eines aus den Pfaden 25, 26 zusammengesetzten Pfadsystems 30 vorzugsweise derart bewegt, dass in einer erste Phase der Laserbeaufschlagung der Fokus 18 der Laserstrahlung 16 zunächst längs der ersten Pfade 25 bewegt wird, die sich in einem Abstand a von der Vorderseite 19 des Wafers 10 befinden und parallel zu den in **Fig. 1** dargestellten Teilungslinien 12 verlaufen. Anschließend erfolgt eine Bewegung des Fokus 18 längs den parallel zu den Teilungslinien 11 (**Fig. 1**) verlaufenden Pfaden 25.

Die Bewegung des Fokus 18 längs den Pfaden 25 erfolgt vorzugsweise derart, dass der Fokus 18 mit konstanter Geschwindigkeit längs den Pfaden 25 bewegt wird und eine die Laserstrahlung 16 emittierende, hier nicht näher dargestellte Laserquelle im Pulsbetrieb betrieben wird. Durch die fokussierte Laserstrahlung werden längs der Pfade 25 durch partielles Aufschmelzen des monokristallinen Siliziums polykristalline Enklaven in dem Siliziumkörper erzeugt, die aufgrund des größeren Volumens der polykristallinen Struktur Druckspannungen im Siliziumkörper induzieren. Die Pfade 25 bilden mit den durch die polykristallinen Enklaven ausgebildeten Fehlstellen 28 parallel zur Vorderseite des Wafers 10 verlaufende Linien erhöhter Spannung.

Nachfolgend der Erzeugung der im Teilungsraster 27 angeordneten ersten Pfade 25, die sich in dem Abstand a von der Vorderseite 19 des Wafers befinden, erfolgt eine Fokussierung der Laserstrahlung 16 derart, dass sich der Fokus 18 in einem Abstand b von der Vorderseite 19 des Wafers 10 befindet und anschließend der Fokus 18 entsprechend dem Teilungsraster 27 längs den zweiten Pfaden 26 durch den Siliziumkörper bewegt wird und Fehlstellen 29 ausgebildet werden.

Die Laserbeaufschlagung längs der ersten Pfade 25 und der zweiten Pfade 26 erfolgt mit unterschiedlicher Leistungsdichte, nämlich derart, dass die Leistungsdichte zur Erzeugung der Fehlstellen 28 auf den ersten Pfaden 25 geringer ist als die Leistungsdichte zur Erzeugung der Fehlstellen 29 auf den zweiten Pfaden 26. Dies hat zur Folge, dass die durch die Fehlstellen 29 der zweiten Pfade 26 im Siliziumkörper 20 induzierten Spannungen größer sind als die durch die Fehlstellen 28 der Pfade 25 induzierten Spannungen.

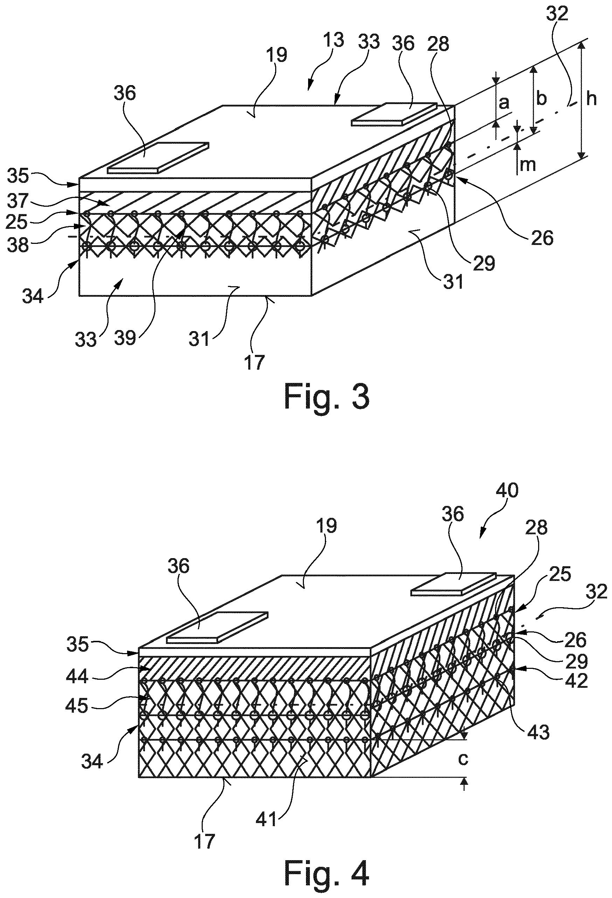

Nachfolgend der Erzeugung des entsprechend dem Teilungsraster 27 im Siliziumkörper 20 des Wafers 10 ausgebildeten Pfadsystems 30 mit den Pfaden 25 und 26 und den entsprechenden Fehlstellen 28 und 29 erfolgt eine Beaufschlagung des Wafers 10 mit einer Kraft F mit der Folge, dass der Wafer 10 in den durch das Pfadsystem 30 definierten Teilungsebenen 21, 22, 23, 24 bricht, so dass die Teilungsebenen 21, 22, 23, 24 Seitenflächen 31 des in **Fig. 3** dargestellten vereinzelten Chips 13 ausbilden.

**Fig. 3** zeigt den Chip 13 mit vier Seitenflächen 31, die jeweils längs des ersten Pfades 25 Fehlstellen 28 und längs des zweiten Pfades 26 Fehlstellen 29 aufweisen. Die im Vergleich zu den Fehlstellen 29 des zweiten Pfads 26 mit geringerer Leistungsdichte erzeugten Fehlstellen 28 des ersten Pfads 25 sind bei dem in **Fig. 3** dargestellten Ausführungsbeispiel kleiner ausgebildet. Der Pfad 25 mit den Fehlstellen 28 befindet sich in dem Abstand a von der Vorderseite 19 des Chips 13, der etwa 40 % des Abstands m der Vorderseite 19 von einer Mittellinie 32 der Seitenflächen 31 beträgt. Der zweite Pfad 26 mit den Fehlstellen 29 befindet sich in dem Abstand b von der Vorderseite 19 bzw. in einem Abstand m von der Mittellinie 32, der etwa 30 % der Höhe h des Chips 13 entspricht und ist unterhalb der Mittellinie 32 angeordnet.

Wie ferner aus der schematischen Darstellung in **Fig. 3** deutlich wird, ist ein Halbleiterkörper 33 des Chips 13 im Wesentlichen unterteilt in eine den wesentlichen Anteil des Halbleiterkörpers 33 ausmachende Halbleiterbasis 34 und eine die Vorderseite 19 des Chips 13 ausbildende Funktionsschicht 35, innerhalb der der Schaltkreis des Chips 13 ausgebildet ist und die mit Chipanschlussflächen 36 versehen ist.

Wie durch die unterschiedlich schraffierten Bereiche der Seitenflächen 31 angedeutet, weisen die Seitenflächen 31 unterschiedliche Oberflächenbereiche 37 und 38 auf. Die Oberflächenbereiche 37 und 38 unterscheiden sich im Wesentlichen durch ihre Topographie, derart, dass die Oberflächenrauheit des zwischen dem ersten Pfad 25 und der Funktionsschicht 35 ausgebildeten Oberflächenbereichs 37 kleiner ist als die Rauheit eines unterhalb des ersten Pfads 25 ausgebildeten Oberflächenbereichs 38, der im Vergleich zum Oberflächenbereich 37 erkennbar Mikrorisse 39 aufweist, die fachterminologisch auch als "Wallner-Linien" bezeichnet werden.

**Fig. 4** zeigt in einer weiteren Ausführungsform einen Chip 40, der mit Seitenflächen 41 versehen ist, die im Unterschied zu den Seitenflächen 31 des in **Fig. 3** dargestellten Chips 13 zusätzlich zu dem ersten und zweiten Pfad 25, 26 einen dritten Pfad 42 mit Fehlstellen 43 aufweisen, wobei der dritte Pfad 42 zwischen dem zweiten Pfad 26 und der Rückseite 17 des Halbleiterkörpers 33 verläuft.

Wie aus der schematischen Darstellung der Seitenflächen 41 in **Fig. 4** erkennbar, ist auch bei dem in **Fig. 4** dargestellten Chip 40 eine Differenzierung zwischen Oberflächenbereichen 44, 45 möglich, die durch den ersten Pfad 25 voneinander getrennt werden.

Analog zu dem Bezug nehmend auf **Fig. 3** erläuterten Chip 13 ist auch bei dem in **Fig. 4** dargestellten Chip 40 der zwischen der Funktionsschicht 35 des Chips 40 und dem ersten Pfad 25 ausgebildete Oberflächenbereich 44 mit einer im Vergleich zum Oberflächenbereich 45 geringeren Rauheit versehen.

Wie aus der schematischen Darstellung in **Fig. 4** erkennbar sind die Fehlstellen 28, 29, 43 bei dem dargstellten Ausführungsbeispiel unterschiedlich groß ausgebildet, da die Fehlstellen 28, 29 und 43 mit unterschiedlicher Leistungsdichte erzeugt sind, wobei die Leistungsdichte der Fehlstellen 28 des ersten Pfads 25 etwa 70 % der Leistungsdichte zur Erzeugung der Fehlstellen 29 des zweiten Pfads 26 und die Leistungsdichte zur Erzeugung der Fehlstellen 43 des dritten Pfads 42 etwa 25 % der Leistungsdichte zur Erzeugung der Fehlstellen 29 des zweiten Pfads 26 beträgt.

## Patentansprüche

1. Verfahren zur Vereinzelung von Chips (13, 40) aus einem Wafer unter Ausbildung einer Rissbarriere gegen die mechanisch belastungsinduzierte Ausweitung von Mikrorissen in Richtung auf die Funktionsschicht des Chips
durch Teilung des Wafers (10) längs Abmessungen des Chips definierenden Teilungslinien (11, 12), wobei ein Fokus (18) einer gepulsten Laserstrahlung (16) längs den Teilungslinien auf einem ersten und zumindest einem zweiten Pfad (25, 26) innerhalb des Waferkörpers bewegt wird,
derart, dass auf den Pfaden infolge partiellen Aufschmelzens des monokristallinen Siliziumkörpers (20) polykristalline Fehlstellen (28, 29, 43) zur Erzeugung innerer Spannungen im Siliziumkörper ausgebildet werden,
und wobei nachfolgend der Erzeugung eines Pfadsystems (30) aus ersten und zweiten Pfaden eine Beaufschlagung des Wafers mit einer mechanischen Belastung erfolgt zur Vereinzelung der Chips aus dem Wafer infolge eines Materialbruchs in durch den ersten und zweiten Pfad definierten Teilungsebenen (21, 22, 23, 24), die Seitenflächen (31, 41) der Chips ausbilden,
wobei die Laserbeaufschlagung des Wafers von einer Rückseite (17) des Wafers her erfolgt, wobei die Erzeugung des ersten Pfads (25) vor Erzeugung des zweiten Pfads (26) erfolgt, und der erste Pfad (25) zwischen einer an der Vorderseite (19) des Wafers angeordneten Funktionsschicht (35) und der Mittelebene (32) des Wafers sowie näher an der Vorderseite (19) als der zweite Pfad (26) verläuft, und der erste Pfad einen ersten Oberflächenbereich (38, 45) der Chip-Seitenflächen (31, 41) von einem zwischen der Funktionsschicht und dem ersten Pfad ausgebildeten zweiten Oberflächenbereich (37, 44) trennt, **dadurch gekennzeichnet, dass** die Leistungsdichte zur Erzeugung der Fehlstellen (28) auf dem ersten Pfad (25) geringer ist als die Leistungsdichte zur Erzeugung der Fehlstellen (29) auf dem zweiten Pfad (26), und/oder die Anzahl der Fehlstellen auf dem ersten Pfad kleiner ist als die Anzahl der Fehlstellen auf dem zweiten Pfad, wobei im Bereich des zweiten Pfads größere innere Spannungen als im Bereich des ersten Pfads induziert werden und somit ein abfallender Spannungsgradient zwischen den längs dem zweiten Pfad und dem ersten Pfad durch die Fehlstellen induzierten inneren Spannungen ausgebildet wird,
wobei der erste Pfad aufgrund des in Richtung des ersten Pfads abfallenden Spannungsgradienten eine Barriere gegen eine Rissausweitung von in dem ersten Oberflächenbereich (37, 44) vorhandenen Mikrorissen über den ersten Pfad hinaus in Richtung auf die Funktionsschicht des Wafers ausbildet, und
wobei die Differenz der Leistungsdichte zur Erzeugung der Fehlstellen (28) auf dem ersten Pfad (25) zur Leistungsdichte zur Erzeugung der Fehlstellen (29) auf dem zweiten Pfad (26) und/oder die Differenz der Anzahl der Fehlstellen (28) auf dem ersten Pfad (25) gegenüber der Anzahl der Fehlstellen (29) auf dem zweiten Pfad (26) so gewählt wird, dass die Seitenflächen (31, 41) der Chips in einem Oberflächenbereich (37, 44) zwischen dem ersten Pfad und der Vorderseite (19) der Chips (13, 40) gegenüber einem Oberflächenbereich (38, 45) zwischen dem ersten Pfad und dem zweiten Pfad eine geringere Rauheit aufweisen.

2. Verfahren nach Anspruch 1,
**dadurch gekennzeichnet,**
**dass** der zweite Pfad (26) benachbart zu oder in einer Mittelebene (32) des Wafers (10) erzeugt wird.

3. Verfahren nach Anspruch 2,
**dadurch gekennzeichnet,**
**dass** ein dritter Pfad (42) zwischen der Mittelebene (32) und der Rückseite (17) des Wafers (10) erzeugt wird.

4. Verfahren nach einem der vorangehenden Ansprüche,
**dadurch gekennzeichnet,**
**dass** die Leistungsdichte zur Erzeugung der Fehlstellen (28) des ersten Pfads (25) maximal 90 %, bevorzugt 80 %, besonders bevorzugt 75 % der Leistungsdichte zur Erzeugung der Fehlstellen (29) des zweiten Pfads (26) beträgt.

5. Verfahren nach Anspruch 3,
**dadurch gekennzeichnet,**
**dass** die Leistungsdichte zur Erzeugung der Fehlstellen (43) des dritten Pfads (42) maximal 50 %, bevorzugt 40 %, besonders bevorzugt 30 % der Leistungsdichte zur Erzeugung der Fehlstellen (29) des zweiten Pfads (26) beträgt.

6. Chip (13, 40) mit einem Halbleiterkörper (33) aus Silizium und einer an einer Vorderseite (19) des Halbleiterkörpers ausgebildeten, durch eine Halbleiterbasis (34) von einer Rückseite (17) des Halbleiterkörpers beabstandeten Funktionsschicht (35),
wobei der Halbleiterkörper Seitenflächen (31, 41) aufweist mit Oberflächenbereichen (37, 38; 44, 45), die eine unterschiedliche Topographie aufweisen, und die zumindest zwei mit Abstand von der Rückseite auf den Seitenflächen verlaufende, durch Fehlstellen (28, 29) in der Seitenfläche des Halbleiterkörpers markierte Pfade (25, 26) aufweisen, wobei der erste Pfad (25) zwischen der Funktionsschicht (35) und dem zweiten Pfad (26) angeordnet ist,
und wobei der erste Pfad eine Barriere ausbildet, die einen ersten Oberflächenbereich (38, 45) von einem zwischen der Funktionsschicht und der Barriere ausgebildeten zweiten Oberflächenbereich (37, 44) trennt, wobei die Anzahl und/oder Größe der Fehlstellen auf dem ersten Pfad kleiner ist als die Anzahl und/oder Größe der Fehlstellen auf dem zweiten Pfad, **dadurch gekennzeichnet, dass** der zweite Oberflächenbereich eine geringere Oberflächenrauheit als der erste Oberflächenbereich aufweist, und der erste Oberflächenbereich Mikrorisse (39) aufweist,
und wobei die in dem Oberflächenbereich (38, 45) mit höherer Rauhtiefe vorhandenen Wallner-Linien (39) sich bis zum ersten Pfad (25) erstrecken, jedoch nicht über den ersten Pfad hinaus.

7. Chip nach Anspruch 6,
**dadurch gekennzeichnet,**
**dass** der zweite Pfad (26) benachbart zu oder auf einer Mittellinie (32) der Seitenfläche (31, 41) verläuft.

8. Chip nach Anspruch 7,
**dadurch gekennzeichnet,**
**dass** ein dritter Pfad (42) zwischen der Mittellinie (32) und der Rückseite (17) des Halbleiterkörpers (33) verläuft.

9. Chip nach einem der Ansprüche 6 bis 8,
**dadurch gekennzeichnet,**
**dass** der dritte Pfad (26) in einem Oberflächenbereich der Seitenfläche (31, 41) verläuft, der durch die Mittellinie (32) und die Rückseite (17) des Halbleiterkörpers (33) begrenzt ist, und der dritte Pfad in einem Abstand m von der Mittellinie verläuft, der 30 % der Höhe h des Halbleiterkörpers entspricht.

10. Chip nach einem der Ansprüche 6 bis 9,
**dadurch gekennzeichnet,**
**dass** der erste Pfad (25) in einem Abstand a von der Vorderseite (19) des Halbleiterkörpers (33) verläuft, der größer ist als 30 % des Abstands h/2 der Vorderseite von der Mittellinie (32) der Seitenfläche (31, 41).

11. Chip nach einem der Ansprüche 6 bis 10,
**dadurch gekennzeichnet,**
**dass** der erste Pfad (25) in einem Abstand a von der Vorderseite (19) des Halbleiterkörpers (33) verläuft, der größer ist als 40 % des Abstands h/2 der Vorderseite von der Mittellinie (32) der Seitenfläche (31, 41).

12. Chip nach einem der Ansprüche 6 bis 10,
**dadurch gekennzeichnet,**
**dass** der erste Pfad (25) in einem Abstand a von der Vorderseite (19) des Halbleiterkörpers (33) verläuft, der kleiner ist als 50 % des Abstands h/2 der Vorderseite von der Mittellinie (32) der Seitenfläche (31, 41).

13. Chip nach einem der Ansprüche 6 bis 12,
**dadurch gekennzeichnet,**
**dass** der dritte Pfad (42) in einem Abstand c von der Rückseite (17) des Halbleiterkörpers (33) verläuft, der größer ist als 10 % der Höhe h des Halbleiterkörpers.

## Claims

1. A method for separating chips (13, 40) from a wafer while forming
a crack barrier against the propagation of micro cracks, induced by mechanical loads, in the direction of the functional layer of the chip
by dividing the wafer (10) along dividing lines (11, 12) defining dimensions of the chip,
wherein a focus (18) of a pulsed laser radiation (16) is moved along the dividing lines on a first and at least a second path (25, 26) within the wafer body,
in such a manner that polycrystalline defects (28, 29, 43) for producing internal stresses in the silicon body (20) are formed on the paths as a result of a partial melting of the monocrystalline silicon body,
and wherein following the production of a path system (30) of first and second paths, the wafer is subjected to a mechanical load so as to separate the chips from the wafer by way of a material fracture in dividing planes (21, 22, 23, 24) which are defined by the first and second path and form lateral surfaces (31, 41) of the chips,
wherein the laser radiation is applied to the wafer from a rear side (17) of the wafer,
wherein the production of the first path (25) takes place prior to the production of the second path (26),
and the first path (25) runs between a functional layer (35) arranged on the front side (19) of the wafer and the centre plane (32) of the wafer as well as closer to the front side (19) than the second path (26),
and the first path separates a first surface area (38, 45) of the lateral faces (31, 41) of the chip from a second surface area (37, 44) formed between the functional layer and the first path,
**characterized in that**
the power density for producing the defects (28) on the first path (25) is lower than the power density for producing the defects (29) on the second path (26), and/or the number of defects on the first path is smaller than the number of defects on the second path,
wherein in the area of the second path greater internal stresses are induced than in the area of the first path and thus a falling stress gradient is formed between the internal stresses induced along the second path and the first path by the defects,
wherein the first path, due to the stress gradient falling in the direction of the first path, forms a barrier against crack propagation of micro cracks present in the first surface area (37, 44) beyond the first path in the direction of the functional layer of the wafer, and
wherein the difference between the power density for producing the defects (28) on the first path (25) and the power density for producing the defects (29) on the second path (26) and/or the difference between the number of defects (28) on the first path (25) and the number of defects (29) on the second path (26) is selected such that the lateral surfaces (31, 41) of the chips exhibit a lower roughness in a surface area (37, 44) between the first path and the front side (19) of the chips (13, 40) as compared to a surface area (38, 45) between the first path and the second path.

2. The method according to claim 1,
**characterized in that**
the second path (26) is produced adjacent to or in a centre plane (32) of the wafer (10).

3. The method according to claim 2,
**characterized in that**
a third path (42) is produced between the centre plane (32) and the rear side (17) of the wafer (10).

4. The method according to any of the preceding claims,
**characterized in that**
the power density for producing the defects (28) of the first path (25) is at maximum 90 %, preferably 80 %, particularly preferably 75 %, of the power density for producing the defects (29) of the second path (26).

5. The method according to claim 3,
**characterized in that**
the power density for producing the defects (43) of the third path (42) is at maximum 50 %, preferably 40 %, particularly preferably 30 %, of the power density for producing the defects (29) of the second path (26).

6. A chip (13, 40) having a semiconductor body (33) of silicon and a functional layer (35) which is formed on a front side (19) of the semiconductor body and is spaced from a rear side (17) of the semiconductor body by a semiconductor base (34),
wherein the semiconductor body has lateral surfaces (31, 41) with surface areas (37, 38; 44, 45) which have a differing topography, and which have at least two paths (25, 26) which run at a distance from the rear side on the lateral surfaces and are marked by defects (28, 29) in the lateral surface of the semiconductor body,
wherein the first path (25) is arranged between the functional layer (35) and the second path (26),
and wherein the first path forms a barrier which separates a first surface area (38, 45) from a second surface area (37, 44) which is formed between the functional layer and the barrier,
wherein the number and/or dimension of the defects on the first path is smaller than the number and/or dimension of the defects on the second path,
**characterized in that**
the second surface area exhibits a lower surface roughness than the first surface area, and the first surface area has micro cracks (39), and wherein the Wallner lines (39) present in the surface area (38, 45) with higher surface roughness extend as far as to the first path (25) but not beyond the first path.

7. The chip according to claim 6,
**characterized in that**
the second path (26) runs adjacent to or on a centre line (32) of the lateral surface (31, 41).

8. The chip according to claim7,
**characterized in that**
a third path (42) runs between the centre line (32) and the rear side (17) of the semiconductor body (33).

9. The chip according to any of the claims 6 to 8,
**characterized in that**
the third path (26) runs in a surface area of the lateral surface (31, 41) which is delimited by the centre line (32) and the rear side (17) of the semiconductor body (33), and the third path runs at a distance m from the centre line, said distance corresponding to 30 % of the height h of the semiconductor body.

10. The chip according to any of the claims 6 to 9,
**characterized in that**
the first path (25) runs at a distance a from the front side (19) of the semiconductor body (33), said distance being larger than 30 % of the distance h/2 between the front side and the centre line (32) of the lateral surface (31, 41).

11. The chip according to any of the claims 6 to 10,
**characterized in that**
the first path (25) runs at a distance a from the front side (19) of the semiconductor body (33), said distance being larger than 40 % of the distance h/2 between the front side and the centre line (32) of the lateral surface (31, 41).

12. The chip according to any of the claims 6 to 10,
**characterized in that**
the first path (25) runs at a distance a from the front side (19) of the semiconductor body (33), said distance being smaller than 50 % of the distance h/2 between the front side and the centre line (32) of the lateral surface (31, 41).

13. The chip according to any of the claims 6 to 12,
**characterized in that**
the third path (42) runs at a distance c from the rear side (17) of the semiconductor body (33), said distance being larger than 10 % of the height h of the semiconductor body.

## Revendications

1. Procédé de séparation individuelle de puces (13, 40) à partir d'une plaquette tout en formant une barrière de fissures contre la propagation de microfissures, induite par des charges mécaniques, dans la direction de la couche fonctionnelle de la puce en partageant la plaquette (10) le long de lignes de partition (11, 12) définissant les dimensions de la puce, un foyer (18) d'un rayonnement laser (16) pulsé étant déplacé le long des lignes de partition sur une première voie et au moins une deuxième voie (25, 26) dans le corps de la plaquette,
de telle manière que des défauts polycristallins (28, 29, 43) destinés à produire des tensions internes dans le corps en silicium (20) monocristallin sont formés sur les voies par suite d'une fusion partielle du corps en silicium,
et dans lequel, après la production d'un système de voies (30) se composant de premières et deuxièmes voies, la plaquette est soumise à une charge mécanique afin de séparer individuellement les puces à partir de la plaquette par suite d'une fracture de matériau dans des plans de partition (21, 22, 23, 24) qui sont définis par les premières et deuxièmes voies et qui forment les faces latérales (31, 41) des puces,
le rayonnement laser étant appliqué à la plaquette par une face arrière (17) de la plaquette,
la première voie (25) étant produite avant la production de la deuxième voie (26), et la première voie (25) s'étendant entre une couche fonctionnelle (35), qui est disposée sur la face avant (19) de la plaquette, et le plan central (32) de la plaquette ainsi que plus près de la face avant (19) que la deuxième voie (26),
et la première voie séparant une première zone de surface (38, 45) des faces latérales (31, 41) de la puce d'une deuxième zone de surface (37, 44) formée entre la couche fonctionnelle et la première voie,
**caractérisé en ce que**
la densité de puissance pour la production des défauts (28) sur la première voie (25) est inférieure à la densité de puissance pour la production des défauts (29) sur la deuxième voie (26), et/ou le nombre de défauts sur la première voie est inférieure au nombre de défauts sur la deuxième voie,
des tensions internes plus grandes étant induites dans la région de la deuxième voie que dans la région de la première voie, ainsi formant un gradient de tension décroissant entre les tensions internes induites le long de la deuxième voie et la première voie par les défauts,
la première voie, à cause du gradient de tension décroissant dans la direction de la première voie, formant une barrière contre une propagation de microfissures existant dans la première zone de surface (37, 44) au-delà de la première voie dans la direction de la couche fonctionnelle de la plaquette, et
la différence entre la densité de puissance pour la production des défauts (28) sur la première voie (25) et la densité de puissance pour la production des défauts (29) sur la deuxième voie (26) et/ou la différence entre le nombre de défauts (28) sur la première voie (25) et le nombre de défauts (29) sur la deuxième voie (26) étant sélectionnée de telle manière que les faces latérales (31, 41) des puces présentent une rugosité inférieure dans une zone de surface (37, 44) entre la première voie et la face avant (19) des puces (13, 40) comparée à la zone de surface (38, 45) entre la première voie et la deuxième voie.

2. Procédé selon la revendication 1,
**caractérisé en ce que**
la deuxième voie (26) est produite adjacent à ou dans un plan central (32) de la plaquette (10).

3. Procédé selon la revendication 2,
**caractérisé en ce qu'**
une troisième voie (42) est produite entre le plan central (32) et la face arrière (17) de la plaquette (10).

4. Procédé selon l'une quelconque des revendications précédentes,
**caractérisé en ce que**
la densité de puissance pour la production des défauts (28) de la première voie (25) est de 90 % au maximum, de préférence de 80 %, notamment de préférence de 75 % de la densité de puissance pour la production des défauts (29) de la deuxième voie (26).

5. Procédé selon la revendication 3,
**caractérisé en ce que**
la densité de puissance pour la production des défauts (43) de la troisième voie (42) est de 50 % au maximum, de préférence de 40 %, notamment de préférence de 30 % de la densité de puissance pour la production des défauts (29) de la deuxième voie (26).

6. Puce (13, 40) ayant un corps semi-conducteur (33) en silicium et une couche fonctionnelle (35) qui est formée sur une face avant (19) du corps semi-conducteur et qui est espacée d'une face arrière (17) du corps semi-conducteur par un base semi-conductrice (34),
le corps semi-conducteur comportant des faces latérales (31, 41) qui ont des zones de surface (37, 38; 44, 45) présentant une topographie différente, et qui comportent au moins deux voies (25, 26) s'étendant à une distance de la face arrière sur les faces latérales et étant marquées par des défauts (28, 29) dans la face latérale du corps semi-conducteur, la première voie (25) étant disposée entre la couche fonctionnelle (35) et la deuxième voie (26),
et la première voie formant une barrière qui sépare une première zone de surface (38, 45) d'une deuxième zone de surface (37, 44) formée entre la couche fonctionnelle et la barrière,
le nombre et/ou la dimension des défauts sur la première voie étant inférieur(e) au nombre et/ou à la dimension des défauts sur la deuxième voie,
**caractérisée en ce que**
la deuxième zone de surface a une rugosité de surface inférieure à celle de la première zone de surface, et la première zone de surface présente des microfissures (39),
les lignes de Wallner (39) qui existent dans la zone de surface (38, 45) ayant la rugosité de surface supérieure s'étendant jusqu'à la première voie (25), mais pas au-delà de la première voie.

7. Puce selon la revendication 6,
**caractérisée en ce que**
la deuxième voie (26) s'étend adjacent à ou sur une ligne centrale (32) de la face latérale (31, 41).

8. Puce selon la revendication7,
**caractérisée en ce qu'**
une troisième voie (42) s'étend entre la ligne centrale (32) et la face arrière (17) du corps semi-conducteur (33).

9. Puce selon l'une quelconque des revendications 6 à 8,
**caractérisée en ce que**
la troisième voie (26) s'étend dans une zone de surface de la face latérale (31, 41) qui est limitée par la ligne centrale (32) et la face arrière (17) du corps semi-conducteur (33), et la troisième voie s'étend à une distance m de la ligne centrale, ladite distance correspondant à 30 % de la hauteur h du corps semi-conducteur.

10. Puce selon l'une quelconque des revendications 6 à 9,
**caractérisée en ce que**
la première voie (25) s'étend à une distance a de la face avant (19) du corps semi-conducteur (33), ladite distance étant supérieure à 30 % de la distance h/2 entre la face avant et la ligne centrale (32) de la face latérale (31, 41).

11. Puce selon l'une quelconque des revendications 6 à 10,
**caractérisée en ce que**
la première voie (25) s'étend à une distance a de la face avant (19) du corps semi-conducteur (33), ladite distance étant supérieure à 40 % de la distance h/2 entre la face avant et la ligne centrale (32) de la face latérale (31, 41).

12. Puce selon l'une quelconque des revendications 6 à 10,
**caractérisée en ce que**
la première voie (25) s'étend à une distance a de la face avant (19) du corps semi-conducteur (33), ladite distance étant inférieure à 50 % de la distance h/2 entre la face avant et la ligne centrale (32) de la face latérale (31, 41).

13. Puce selon l'une quelconque des revendications 6 à 12,
**caractérisée en ce que**
la troisième voie (42) s'étend à une distance c de la face arrière (17) du corps semi-conducteur (33), ladite distance étant supérieure à 10 % de la hauteur h du corps semi-conducteur.
